# EUROPÄISCHE PATENTANMELDUNG

(11) **EP 2 816 365 A1**
(43) Veröffentlichungstag der Anmeldung: **24.12.2014**
(21) Anmeldenummer: 13173158.0
(22) Anmeldetag: 21.06.2013
(51) Int. Cl.: G01R 31/34

(54) **Verfahren zum Überprüfen eines Blechpakets eines Generators**

(71) Anmelder: Siemens Aktiengesellschaft, 80333 München (DE)
(72) Erfinder: Evers, Christoph, 46236 Bottrop (DE); Klocke, Meinolf, Dr., 58452 Witten (DE); Mrkulic, Omer, 46539 Dinslaken (DE)

(57) **Zusammenfassung**

Die Erfindung betrifft ein Verfahren zum Überprüfen eines Blechpakets (3) sowie eine Messvorrichtung zum Überprüfen des Blechpakets (3), wobei bei eingebautem Läufer (5) über ein Erregerkabel (7) ein Magnetfeld innerhalb des Blechpakets (3) erzeugt wird und eine Messeinrichtung (9) sowohl in einer axialen (14) Richtung als auch in Umfangsrichtung (18) die Temperatur des Blechpakets (3) ermitteln kann.

## Beschreibung

Die Erfindung betrifft ein Verfahren zum Überprüfen eines Blechpakets eines Generators.

Des Weiteren betrifft die Erfindung eine Messvorrichtung zum Überprüfen eines Blechpakts eines Generators.

Im heutigen Generatorbau ist es erforderlich, Generatoren für die kommunale und kommerzielle Energieerzeugung im Rahmen von Revisionen zur Schadensfrüherkennung auf Störungen zu untersuchen. Störungen können Schäden in der Rotorwicklung oder Schäden im Stator sein. Im Stator können unter anderem Schäden in den Blechpaketen oder in der Ständerwicklung auftreten. Die Blechpakete werden quer zu einer Rotationsachse eingebaut. Zur Aufnahme der Ständerwicklung, die in der Regel aus Kupferleitungen mit rechteckigem Querschnitt besteht, sind die Blechpakete mit Nuten versehen. In die Nuten werden die Ständerwicklungen isoliert eingelegt. Die Ständerwicklung wird gegen die Blechpakete isoliert.

Der Läufer eines Generators weist eine mit elektrischem Strom durchflossene Läuferwicklung auf, wobei die Stromstärke bei modernen Generatoren bis zu 10.000 Ampere betragen kann. Der elektrische Strom wird in der Regel mittels Schleifringen und Kohlebürsten von einer externen Stromversorgung übertragen. Bei Grenzleistungsgeneratoren wird der Erregerstrom durch Erregermaschinen mit rotierenden Gleichrichterrädern erzeugt.

Mit dem elektrischen Strom wird ein rotierendes Magnetfeld erzeugt, das wiederum in der im Statorgehäuse befindlichen Statorwicklung Spannungen induziert. In der Statorwicklung fließt ein elektrischer Strom mit beachtlich hohen Stromstärken. Die hohen Stromstärken führen zu einer Erwärmung der sich in den Nuten befindenden Statorwicklung. Die Isolation zwischen der Statorwicklung und dem Blechpaket könnte beschädigt werden. Tritt ein solcher Schaden auf, erwärmt sich in der lokalen Umgebung der beschädigten Isolation das Blechpaket. Weitere Schäden wären nicht auszuschließen.

Üblicherweise werden die Isolationen zwischen der Statorwicklung in den Blechpaketen auf Schäden untersucht. Eine gängige Prüfmethode ist, den Rotor auszubauen und einen Betriebszustand zu simulieren, der zur Erwärmung des Blechpakets führt. Wenn die Betriebstemperatur erreicht wird, wird mittels einer Infrarotkamera in einer Richtung parallel zur Rotationsachse eine Infrarot-Aufnahme der Statorwicklung und der Blechpakete erstellt. Störungen bzw. Schäden können als sog. "Hot Spots" identifiziert und lokalisiert werden. Vor einer Inbetriebnahme werden die Schäden behoben. Eine Simulation des Betriebszustandes erfolgt heutzutage durch eine Anordnung, die einen Hochspannungsgenerator und mehrere Stränge einer Erregerwicklung aufweist. Die Stränge der Erregerwicklung werden parallel zur Rotationsachse verlegt. Der Hochspannungsgenerator ist mit der Erregerwicklung elektrisch verbunden und liefert eine Ausgangsspannung von bis zu 6 KV bei einer Stromstärkte von ungefähr 700 bis 800 Ampere. Die Wechselspannung induziert in dem Blechpaket einen magnetischen Fluss bzw. ein magnetisches Wechselfeld, die zu einer gewünschten Erwärmung durch Ummagnetisierungsverluste führt, die mit der Erwärmung im Betriebszustand vergleichbar ist.

Aufgabe der Erfindung ist es, ein Verfahren zum Überprüfen eines Blechpakets eines Generators anzugeben, bei dem der Läufer nicht ausgebaut werden muss. Des Weiteren ist es Aufgabe der Erfindung, eine entsprechende Messvorrichtung zum Überprüfen eines Blechpakets eines Generators anzugeben.

Gelöst wird diese Aufgabe durch ein Verfahren zum Überprüfen eines Blechpakets eines Generators, wobei in den Luftspalt zwischen einem Blechpaket und einem Läufer ein Erregerkabel verlegt wird, wobei mittels des Erregerkabels ein Magnetfeld erzeugt wird und Schäden im Blechpaket über eine Messeinrichtung im Luftspalt ermittelt werden.

Vorteilhafte Weiterbildungen sind in den Unteransprüchen angegeben.

Die Erfindung löst somit die Aufgabe bei eingebautem Läufer, ein Ständerblechpaketschluss zu erkennen und zu lokalisieren.

In einer ersten vorteilhaften Weiterbildung wird das Erregerkabel mit einem Wechselstrom liefernden Hochspannungs-Prüfgerät verbunden. Über das Hochspannungs-Prüfgerät wird ein Wechselstrom in das Erregerkabel geführt, wodurch ein Magnetfeld im zu überprüfenden Generator entsteht. Dieses Magnetfeld simuliert annähernd den Zustand im Betrieb. Das bedeutet, dass sich das Ständerblechpaket erwärmt und an den Stellen, an denen eine ungewöhnlich hohe Erwärmung auftaucht, ein möglicher Schaden ist. Dieser mögliche Schaden wird über die Messeinrichtung im Luftspalt ermittelt.

Daher wird in einer vorteilhaften Weiterbildung die Messeinrichtung derart ausgebildet, dass mit dieser Messeinrichtung die Temperatur des Blechpakets ermittelt werden kann.

In einer vorteilhaften Weiterbildung wird die Messeinrichtung innerhalb des Luftspalts mit einer Kamera und einem Laserpointer ausgebildet, um dadurch die Position der Messeinrichtung während des Prüfvorgangs im Luftspalt ermitteln zu können.

In einer weiteren vorteilhaften Weiterbildung werden zwei Führungsseile innerhalb des Luftspalts angeordnet, entlang deren sich die Messeinrichtung axial bewegen lässt.

Dazu wird in einer weiteren vorteilhaften Weiterbildung ein Zugseil mit der Messeinrichtung gekoppelt, wobei durch eine Kraftausübung über das Zugseil das Bewegen der Messeinrichtung in axialer Richtung ermöglicht wird.

In einer besonderen vorteilhaften Weiterbildung wird eine Vorrichtung auf der Läuferkappe installiert, die mit dem Zugseil und den Führungsseilen verbunden ist und derart ausgebildet ist, dass die Messeinrichtung mittels der Vorrichtung auf der Läuferkappe in Umfangsrichtung bewegt werden kann.

Zur Temperaturmessung wird beispielsweise ein Pyrometer eingesetzt.

Ein Ausführungsbeispiel der Erfindung wird anhand der Figuren näher beschrieben. Dabei haben mit den gleichen Bezugszeichen versehene Komponenten dieselbe Funktionsweise.

Die Figuren zeigen in schematischer Weise:
- Figur 1: eine Querschnittansicht eines Generators
- Figur 2: eine Seitenansicht der erfindungsgemäßen Messvorrichtung
- Figur 3: eine weitere Seitenansicht der erfindungsgemäßen Messvorrichtung.

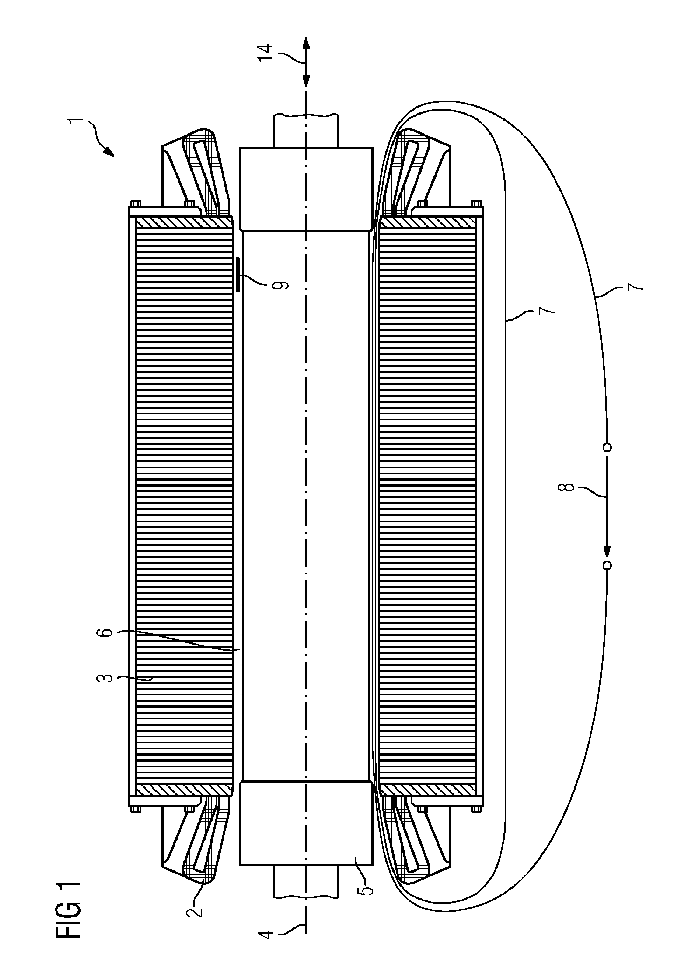

Die Figur 1 zeigt einen Generator 1. Dieser Generator 1 umfasst im Wesentlichen eine Ständerwicklung 2, die innerhalb eines Blechpakets 3 angeordnet ist. Innerhalb der Ständerwicklung 2 rotiert ein um eine Rotationsachse 4 angeordneter Läufer 5. Dieser Läufer 5 umfasst eine nicht näher dargestellte Läuferwicklung, die über eine Erregereinrichtung (nicht dargestellt) mit Strom beaufschlagt wird.

Im Betrieb rotiert der Rotor 5 mit einer Drehzahl von in der Regel 50Hz bzw. 60Hz. Diese Rotation verursacht ein drehendes Magnetfeld innerhalb der Ständerwicklung 2, was zu einer induzierten Spannung in der Ständerwicklung 2 führt.

Während einer Revision oder Reparatur wird der Generator 1 überprüft. Dabei wird bei eingebautem Läufer 5 eine Magnetisierungsprüfung durchgeführt. Dabei wird in einen Luftspalt 6, der zwischen dem Blechpaket 3 und dem Läufer 5 angeordnet ist, ein Erregerkabel 7 verlegt. Mit diesem Erregerkabel 7 ist es möglich ein Magnetfeld innerhalb des Blechpakets 3 zu erzeugen. Dies geschieht, indem das Erregerkabel 7 an ein Wechselstrom lieferndes Hochspannungs-Prüfgerät 8 angeschlossen wird. Durch das im Innern des Blechpakets 3 erzeugte Magnetfeld erfolgt eine Erwärmung des Blechpakets 3. Mögliche Schäden können anschließend durch eine Messeinrichtung 9 detektiert werden.

Daher ist die Messeinrichtung 9 derart ausgebildet, dass sie die Temperatur des Blechpakets 3 ermitteln kann. Üblicherweise wird daher die Messeinrichtung 9 ein Pyrometer 20 umfassen.

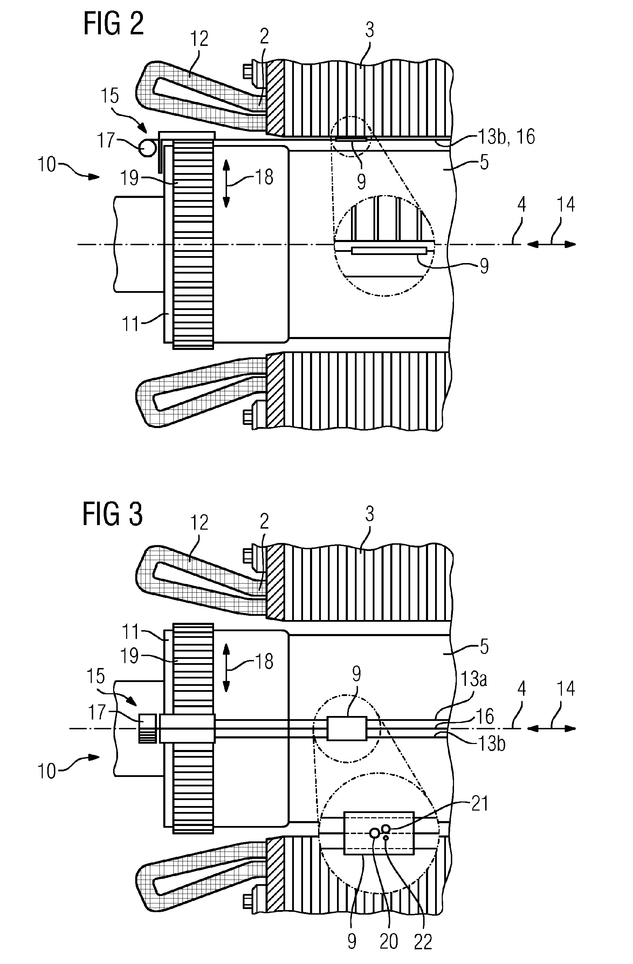

Die Figur 2 zeigt eine Seitenansicht der erfindungsgemäßen Messvorrichtung. Die Messvorrichtung umfasst die Messeinrichtung 9 und ist zum Überprüfen des Blechpakets 3 des Generators 3 ausgebildet. Die Messvorrichtung umfasst eine Führungseinrichtung 10, die zum Bewegen der Messeinrichtung 9 ausgebildet ist. Des Weiteren umfasst die Messvorrichtung eine Erregereinrichtung (in den Figuren 2 und 3 nicht gezeigt), die zum Erzeugen des Magnetfelds im Blechpaket 3 ausgebildet ist.

In Figur 2 ist an den Enden des Rotors 5 jeweils eine Läuferkappe 11 angeordnet, die in der Nähe des Ständerwickelkopfes 12 angeordnet ist.

Die Führungseinrichtung 10 umfasst zwei Führungsseile 13a und 13b, auf denen die Messeinrichtung 9 entlang bewegt werden kann. Diese Bewegung erfolgt in axialer Richtung 14 des Läufers 5. Die Bewegung der Messeinrichtung 9 erfolgt über ein Zugseil 16, das mit der Messeinrichtung 9 verbunden ist. Die Messeinrichtung 9 wird über eine Seilwindeneinheit 15 bewegt. Die Seilwindeneinheit 15 umfasst eine Trommel 17, auf der das Zugseil 16 aufgewickelt werden kann. Die Messeinrichtung 9 ist mit einem Pyrometer 20 zur Messung der Zahntemperatur ausgebildet.

In der Figur 2 ist eine vergrößerte, kreisförmige Darstellung der Messeinrichtung 9 zu sehen. Die Messeinrichtung 9 wird in axialer Richtung 14 bewegt und die Temperatur der Zahntemperatur gemessen. Sofern eine zu hohe Temperatur gemessen wird, liegt möglicherweise ein Schaden im Blechpaket 3 vor.

Die Führungseinrichtung 10 ist derart ausgebildet, dass neben der axialen Bewegung auch eine Bewegung in Umfangsrichtung 18 möglich ist. Dazu ist an der Läuferkappe 11 eine Kette 19 angeordnet, auf der die Seilwindeneinheit 15 mit der Trommel 17 in Umfangsrichtung 18 bewegt werden kann.

Die Figur 3 zeigt eine um 90° versetzte Anordnung der Messeinrichtung gegenüber der Anordnung in Figur 2.

In der Figur 3 ist in einer kreisförmigen Vergrößerung die Messeinrichtung 9 dargestellt, wobei die Messeinrichtung 9 ein Pyrometer 20 zur Messung der Zahntemperatur umfasst. Des Weiteren umfasst die Messeinrichtung 9 eine Kamera 21 und einen Laserpointer 22, mit der die Position der Messeinrichtung 9 bestimmt werden kann.

## Patentansprüche

1. Verfahren zum Überprüfen eines Blechpakets (3) eines Generators (1),
wobei in den Luftspalt (6) zwischen einem Blechpaket (3) und einem Läufer (5) ein Erregerkabel (7) verlegt wird, wobei mittels des Erregerkabels (7) ein Magnetfeld erzeugt wird und Schäden im Blechpaket (3) über eine Messeinrichtung (9) im Luftspalt (6) ermittelt werden.

2. Verfahren nach Anspruch 1,
wobei das Erregerkabel (7) mit einem Wechselstrom liefernden Hochspannungs-Prüfgerät (8) verbunden wird.

3. Verfahren nach Anspruch 1 oder 2,
wobei mit der Messeinrichtung (9) die Temperatur des Blechpakets (3) ermittelt werden kann.

4. Verfahren nach Anspruch 1, 2 oder 3,
wobei die Position der Messeinrichtung (9) innerhalb des Luftspalts (6) mit einer Kamera (21) und einem Laserpointer (22) auf der Messeinrichtung (9) ermittelt wird.

5. Verfahren nach einem der vorhergehenden Ansprüche,
wobei die Messeinrichtung (9) auf Führungsseilen (13a, 13b) innerhalb des Luftspalts (6) bewegt werden kann.

6. Verfahren nach Anspruch 5,
wobei die Messeinrichtung (9) mit einem Zugseil (16) in einer axialen Richtung (14) im Luftspalt (6) bewegt werden kann.

7. Verfahren nach einem der Ansprüche 1 bis 6,
wobei die Messeinrichtung (9) mittels einer Vorrichtung auf den Läuferkappen (11) in Umfangsrichtung (18) bewegt werden kann.

8. Messvorrichtung zum Überprüfen eines Blechpakets (3) eines Generators (1),
umfassend eine Messeinrichtung (9) zum Ermitteln der Temperatur im Blechpaket (3),
eine Führungseinrichtung (10), die zum Bewegen der Messeinrichtung (9) ausgebildet ist,
eine Erregereinrichtung zum Erzeugen eines Magnetfeldes im Blechpaket (3).

9. Messvorrichtung nach Anspruch 8,
wobei die Führungseinrichtung (10) mit Führungsseilen (13a, 13b) gebildet ist, auf dem die Messeinrichtung (9) bewegbar angeordnet ist.

10. Messvorrichtung nach Anspruch 8 oder 9,
wobei die Führungseinrichtung (10) derart ausgebildet ist, dass die Messeinrichtung (9) in axialer (14) und in Umfangsrichtung (18) bewegbar ist.

11. Messvorrichtung nach einem der Ansprüche 8 bis 10,
wobei die Messeinrichtung (9) mit einem Zugseil (16) verbunden ist und über das Zugseil (16) die axiale Bewegung erfolgt.

12. Messvorrichtung nach einem der Ansprüche 8 bis 11,
wobei die Erregereinrichtung ein Wechselstrom lieferndes Hochspannungs-Prüfgerät (8) umfasst.
